# EUROPÄISCHE PATENTSCHRIFT

(11) **EP 3 216 329 B1**
(45) Veröffentlichungstag und Bekanntmachung des Hinweises auf die Patenterteilung: **11.07.2018**
(21) Anmeldenummer: 15787982.6
(22) Anmeldetag: 28.10.2015
(51) Int. Cl.: H05K 3/20, H05K 3/00, B29C 45/14, B23K 31/02

(54) **VERFAHREN ZUM HERSTELLEN EINER ANORDNUNG MIT EINEM GEHÄUSETEIL UND WENIGSTENS ZWEI LEITERBAHNEN**
METHOD FOR MANUFACTURING AN ARRANGEMENT COMPRISING A HOUSING PART AND AT LEAST TWO CONDUCTOR PATHS
PROCÉDÉ DE FABRICATION D'UN ENSEMBLE COMPRENANT UNE PIÈCE DE BOÎTIER ET AU MOINS DEUX RUBANS CONDUCTEURS

(30) Priorität: 05.11.2014 DE 102014222597
(43) Veröffentlichungstag der Anmeldung: 13.09.2017
(73) Patentinhaber: MAHLE International GmbH, 70376 Stuttgart (DE)
(72) Erfinder: VAN EICKELS, Bernd, 73733 Esslingen (DE); NIEKAMP, Peer, 71397 Leutenbach (DE)
(74) Vertreter: BRP Renaud & Partner mbB Rechtsanwälte Patentanwälte Steuerberater
(86) Internationale Anmeldenummer: PCT/EP2015/075013
(87) Internationale Veröffentlichungsnummer: WO 2016/071181

(56) Entgegenhaltungen:
- EP-A1- 2 525 634
- DE-C1- 4 323 827
- US-A1- 2008 102 716

## Beschreibung

Die Erfindung betrifft ein Verfahren zum Herstellen einer Anordnung mit einem Gehäuseteil und wenigstens zwei Leiterbahnen aus Blechformteilen.

Zur Steuerung elektrischer/elektronischer Komponenten eines Kraftfahrzeugs sowie zur Versorgung dieser Komponenten mit elektrischer Energie sind üblicherweise eine Vielzahl von elektrischen Leitungen erforderlich. Aus dem Stand der Technik ist es bekannt, solche Leitungen in Form von Blechformteilen zu realisieren, die elektrische Leiterbahnen ausbilden. Die die Leiterbahnen bildenden Blechformteile können zusammen mit weiteren elektrischen/elektronischen Bauteilen unter Verwendung geeigneter Spritzgusswerkzeuge mit einem Kunststoffgehäuse umspritzt werden. Dabei können die Blechformteile bzw. Leiterbahnen bei Verwendung geeigneter Spritzgusswerkzeuge zur Ausbildung von elektrischen Anschlüssen auch durch das Gehäuse nach außen durchgeführt werden.

Derartige Anordnungen mit Leiterbahnen und einem um die Leiterbahnen gespritzten Kunststoffgehäuse kommen in Kraftfahrzeugen beispielsweise bei der elektrischen Verdrahtung von elektrischen Aktuatoren für Wastegate-Ventile o.ä. zum Einsatz.

Als nachteilig bei derartigen, aus dem Stand der Technik bekannten Anordnungen erweist sich, dass für unterschiedliche elektrische Anwendungen jeweils ein individueller Satz von Leiterbahnen bzw. Blechformteilen neu konzipiert und hergestellt werden muss, obwohl sich die für verschiedene Anwendungen eigentlich erforderlichen Leiterbahnen nur geringfügig voneinander unterscheiden. Dies gilt beispielsweise, wenn mit Hilfe besagter Leiterbahnen Aktuatoren technisch ähnlicher Bauformen von Wastegate-Ventilen elektrisch verdrahtet werden sollen.

Vor diesem Hintergrund beschreibt die die EP 2 525 634 A1 ein Verfahren zum Herstellen einer elektrischen Spule eines Transformators. Hierfür wird ein Substrat mit mehreren Leiterbahnen mit einem Kunststoff bedeckt, wobei ein Befestigungsabschnitt frei von Kunststoff bleibt. Am Befestigungsabschnitt kann später eine elektronische Komponente angebracht werden und elektrisch mit den Leiterbahnen verbunden werden. Dies geschieht aber erst, nachdem die Leiterbahnen bereits in den Kunststoff eingebettet sind.

Die DE 43 23 827 C1 offenbart ein Verfahren zum Herstellen einer Leiterplatte. Zur Herstellung der Leiterplatte werden zwei Stanzgitter in zwei zueinander parallelen Ebenen angeordnet. An Stellen, an welchen direkte elektrische Verbindungen zwischen den Stanzgittern erzeugt werden sollen, werden Verbindungslappen aus der jeweiligen Leiterbahn eben herausgebogen, so dass sie parallel zueinander anliegen und auf diese Weise leicht miteinander verschweißt werden können. Die in parallelen Ebenen zueinander angeordneten Stanzgitter werden in Kunststoff eingebettet, wodurch die Leiterplatte entsteht.

Auch die US 2008/0102716 offenbart ein derartiges Verfahren.

Es ist eine Aufgabe der vorliegenden Erfindung, ein Herstellungsverfahren zum Herstellen einer Anordnung mit einem Gehäuseteil und wenigstens zwei Leiterbahnen zu schaffen.

Diese Aufgabe wird durch den Gegenstand der unabhängigen Patentansprüche gelöst. Bevorzugte Ausführungsformen sind Gegenstand der abhängigen Patentansprüche.

Grundgedanke der Erfindung ist es demnach, eine erste und eine zweite Leitungsbahn jeweils in Form eines Blechformteils zunächst separat auszubilden und anschließend mit Hilfe eines geeigneten Spritzgusswerkzeugs wenigstens teilweise mit Kunststoff zu umspritzen, so dass ein gemeinsames Gehäuseteil für die Leiterbahnen gebildet wird. Erst nach dem Umspritzen werden die beiden Leiterbahnen stoffschlüssig, typischerweise mittels einer Schweißverbindung, miteinander verbunden.

Mittels der im erfindungsgemäßen Verfahren realisierten Idee, eine stoffschlüssige Verbindung zweier Leiterbahnen erst nach deren Umspritzen mit einem Kunststoff herzustellen, wird verhindert, dass die Leiterbahnen für den Umspritzvorgang mit einem an der stoffschlüssigen Verbindung typischerweise entstehenden mechanischen Verzug in das Formwerkzeug eingelegt werden können. Dies könnte so weit gehen, dass die zu umspritzenden Leiterbahnen nur unter mechanischer Spannung in das Formwerkzeug eingelegt werden können. Darüber hinaus erweist sich das beim erfindungsgemäßen Verfahren mögliche Einlegen der einzelnen, noch nicht stoffschlüssig miteinander verbundenen Leiterbahnen mit relativ einfacher geometrischer Formgebung sowie relativ begrenzten äußeren Abmessungen als weitaus unkomplizierter und somit einfacher als das Einsetzen eines bereits stoffschlüssig miteinander verbundenen, und somit relativ komplizierten geometrischen Gebildes aus zwei oder gar mehr Leiterbahnen.

Die einzelnen Leiterbahnen können beim Einlegen in das Formwerkzeug kleinere Toleranzen aufweisen, so dass diese problemlos im Formwerkezug positioniert werden können. Nach dem Umspritzen mit dem Kunststoff sind dann keine mechanischen Spannungen in der entstandenen Anordnung aus dem Gehäuseteil und den wenigstens zwei Leiterbahnen vorhanden, die zu einer unerwünschten Verformung des Gehäuseteils führen könnten.

Das hier vorgestellte Herstellungsverfahren gestattet es außerdem, die erste Leiterbahn einheitlich für verschiedene Anwendungen zu verwenden und die zweite Leiterbahn an verschiedene Anwendungen anzupassen. Sollen unter Verwendung des erfindungsgemäßen Herstellungsverfahrens verschiedene Typen von elektrischen Aktuatoren für Wastegate-Ventile elektrisch verdrahtet werden, so kann für alle Typen ein einheitliches, die erste Leiterbahn ausbildendes Blechformteil verwendet werden. Das die zweite Leiterbahn ausbildende Blechformteil kann hingegen hinsichtlich der Art der elektrischen Verdrahtung - beispielsweise hinsichtlich des Verlaufs der geometrischen Anordnung oder der Dimensionierung der Leiterbahnen individuell an jeden elektrischen Aktuator angepasst werden. Insbesondere kann die erste Leiterbahn speziell für die Integration spezifischer elektrischer Komponenten wie beispielsweise elektrischer Kondensatoren o.ä. in die Leiterbahn konzipiert werden. Da ein oder beide Endabschnitte des die zweite Leiterbahn ausbildenden Blechformteils typischerweise einen elektrischen Anschluss bildet, der elektrisch mit externen Leitungspfaden verbunden werden kann, können durch geeignete Ausbildung der zweiten Leiterbahn individuell angepasste elektrische Anschlüsse geschaffen werden.

Das erfindungsgemäße Verfahren ist dabei nicht nur zur Herstellung einer Anordnung mit genau einer ersten Leiterbahn und einer zweiten Leiterbahn geeignet, sondern entfaltet seine vorteilhafte Wirkung gerade dann, wenn eine Mehrzahl von ersten Leiterbahnen mit derselben Anzahl an zweiten Leiterbahnen verbunden werden soll. Auf diese Weise können im gemeinsamen Gehäuseteil eine Vielzahl von - zueinander elektrisch isolierten - Leitungen verdrahtet werden.

Das erfindungsgemäße Herstellungsverfahren umfasst die folgenden vier Schritte a), b), c) und d):
In einem ersten Schritt a) des Herstellungsverfahrens wird wenigstens ein eine erste Leiterbahn ausbildendes Blechformteil bereitgestellt. Weiterhin wird wenigstens ein weiteres Blechformteil, welches eine zweite Leiterbahn ausbildet, bereitgestellt. Die durch Blechformteile realisierten Leiterbahnen können etwa aus Blechbahnen ausgestanzt werden und besitzen in diesem Fall typischerweise die Geometrie eines Metallstreifens. Durch geeignete Umformverfahren, insbesondere durch Biegen oder Abkanten, kann den Blechformteilen eine dreidimensionale Struktur verliehen werden.

Im zweiten Verfahrensschritt b) werden die wenigstens eine erste Leiterbahn und die wenigstens eine zweite Leiterbahn in einem Spritzgusswerkzeug angeordnet, welches eine Spritzgießform umfassen kann. Die Anordnung der Leiterbahnen erfolgt dabei derart, dass die erste Leiterbahn zum Herstellen einer elektrischen Verbindung mit der zweiten Leiterbahn diese in wenigstens einer gemeinsamen Kontaktzone berührt. Auf diese Weise kann vermieden werden, dass bei dem zur Ausbildung eines Gehäuseteils noch durchzuführenden Umspritzen der Leiterbahnen mit einem Kunststoff dieser zwischen die Kontaktstellen der beiden Blechformteile bzw. Leiterbahnen gelangt, was zu einer unerwünschten elektrischen Isolation der Leiterbahnen gegeneinander führen würde.

In einem dritten Verfahrensschritt c) werden die wenigstens eine erste Leiterbahn und die wenigstens eine zweite Leiterbahn zur Ausbildung eines Gehäuseteils mit Hilfe des Spritzgusswerkzeugs wenigstens teilweise mit einem Kunststoff umspritzt. Von entscheidendem Vorteil ist dabei, dass der Kunststoff in der gemeinsamen Kontaktzone der Leiterbahnen nicht in Zwischenräume zwischen die Leiterbahnen gelangen kann. Durch das Umspritzen der Leiterbahnen mit Kunststoff in der Spritzgießform wird ein Gehäuseteil ausgebildet, in welchem die Leiterbahnen mechanisch stabil gehalten sind. Das Umspritzen der Leiterbahnen mit Kunststoff kann insbesondere derart erfolgen, dass die erste oder zweite Leiterbahn das Gehäuseteil aus Kunststoff durchgreift. Soll das Gehäuseteil als Gehäusedeckel oder Gehäuseboden eines zwei- oder mehrteiligen Gehäuses fungieren, so können auf diese Weise die Leiterbahnen durch den Gehäusedeckel bzw. - boden durchgeführt werden und als außen am Gehäuseteil bereitgestellte elektrische Anschlüsse verwendet werden.

Im vierten Verfahrensschritt d) wird eine dauerhafte elektrische Verbindung zwischen den Leiterbahnen durch stoffschlüssiges Verbinden der wenigstens einen Leiterbahn und der wenigstens einen zweiten Leiterbahn im Bereich der gemeinsamen Kontaktzone hergestellt. Bevorzugt kann die stoffschlüssige Verbindung als Schweiß- oder Lötverbindung realisiert werden.

In einer bevorzugten Ausführungsform erfolgt das stoffschlüssige Verbinden gemäß Schritt d) erst nach Abkühlen des Gehäuseteils unter einen vorbestimmten Temperatur-Schwellwert. Auf diese Weise wird vermieden, dass das noch heiße Gehäuseteil schädlichen mechanischen Spannungen ausgesetzt wird.

Seine vorteilhafte Wirkung entfaltet das erfindungsgemäße Verfahren gemäß einer bevorzugten Ausführungsform, bei welcher in Schritt a) wenigstens zwei erste Leiterbahnen, vorzugsweise eine Mehrzahl von ersten Leiterbahnen, und wenigstens zwei zweite Leiterbahnen, vorzugsweise eine Mehrzahl von zweiten Leiterbahnen, in Form jeweiliger Blechformteile bereitgestellt werden. Dies bedeutet, dass in Schritt b) für jede erste Leiterbahn und jede zweite Leiterbahn jeweils eine gemeinsame Kontaktzone ausgebildet wird. Auf diese Weise kann eine Vielzahl von ersten und zweiten Leiterbahnen auf die oben beschriebene, erfindungsgemäße Weise am Gehäuseteil fixiert und sodann elektrisch miteinander verbunden werden. Dies ermöglicht die Bereitstellung einer prinzipiell beliebigen Anzahl von Leiterbahnen, so dass jeweils eine erste Leiterbahn und eine elektrisch mit dieser verbundene zweite Leiterbahn eine elektrische Leitung ausbildet. Die verschiedenen elektrischen Leitungen sind dabei elektrisch gegeneinander isoliert. Auf diese Weise lässt sich an dem in der Spritzgießform erzeugten Gehäuseteil unter Anwendung des erfindungsgemäßen Verfahrens eine Vielzahl von elektrischen Leitungen ausbilden, die alle stabil am Gehäuseteil fixiert sind.

In dieser Ausführungsform können auch mehrere erste Leiterbahnen mit jeweils unterschiedlicher Geometrie sowie - alternativ oder zusätzlich - zweite Leiterbahnen mit jeweils unterschiedlicher Geometrie in der Spritzgussform angeordnet werden. Dies gestattet die Herstellung einer Anordnung mit verschiedenartigsten Leiterbahn-Geometrien.

Zur Ausbildung der stoffschlüssigen Verbindung zwischen der ersten und der zweiten Leiterbahn im Bereich der gemeinsamen Kontaktzone eröffnen sich dem Fachmann vielfältige Optionen. Besonders bevorzugt erfolgt das stoffschlüssige Verbinden durch Verschweißen oder Verlöten der jeweiligen Leiterbahnen im Bereich der gemeinsamen Kontaktzone.

In einer weiteren bevorzugten Ausführungsform werden die wenigstens eine erste Leiterbahn und die wenigstens eine zweite Leiterbahn in Schritt b) derart angeordnet, dass die gemeinsame Kontaktzone Teil einer gemeinsamen Fügezone ist. Diese Fügezone wird durch einen ersten Fügeabschnitt der ersten Leiterbahn und einen zweiten Fügeabschnitt der zweiten Leiterbahn gebildet. Die beiden Fügeabschnitte liegen nach dem Anordnen der Leiterbahnen in der Spritzgießform gemäß Schritt b) in der Kontaktzone flächig aneinander an. In einem zur gemeinsamen Kontaktzone komplementären Fügebereich der Fügezone sind die Fügeabschnitte im Abstand zueinander angeordnet, wobei dieser Abstand einen vorbestimmten Höchstwert aufweist. Mit anderen Worten, die Fügezone ist ein Bereich, in welchem der Abstand der beiden Fügeabschnitte zueinander höchstens einen vorbestimmten Maximalwert aufweist. Im Bereich der Kontaktzone, die Teil der Fügezone ist, liegen die beiden Fügeabschnitte, vorzugsweise flächig, aneinander an, d.h. der Abstand der beiden Fügeabschnitte zueinander weist in der Kontaktzone einen Nullwert auf. Die flächige Anlage der beiden Fügeabschnitte aneinander im Bereich der gemeinsamen Kontaktzone und die Anordnung der Fügeabschnitte zueinander im Abstand in dem die Kontaktzone umgebenden Fügebereich ermöglicht die Ausbildung einer besonders guten stoffschlüssigen Verbindung im Zuge von Schritt c) des erfindungsgemäßen Verfahrens.

Eine besonders gute stoffschlüssige Verbindung lässt sich erzielen, wenn der vorbestimmte Maximalwert für den Abstand zwischen den Fügeabschnitten 1mm, bevorzugt 0,5mm, besonders bevorzugt weniger als 0,1mm, beträgt.

In einer vorteilhaften Weiterbildung kann im Zuge von Schritt a) oder in einem oder mehreren dem Schritt a) nachgeschalteten Verfahrensschritten auf der Oberfläche des ersten Fügeabschnitts wenigstens eine erste Erhebung vorgesehen werden. Dies geschieht derart, dass die wenigstens eine Erhebung im Zuge von Schritt b) zur Ausbildung der Kontaktzone an der dem ersten Fügeabschnitt der ersten Leiterbahn zugewandten Oberfläche des zweiten Fügeabschnitts zur Anlage gebracht wird. Eine solche Erhebung bildet also die gemeinsame Kontaktzone zwischen den beiden Leiterbahnen aus. Alternativ oder zusätzlich zur wenigstens einen ersten Erhebung kann auch auf der Oberfläche des zweiten Fügeabschnitts wenigstens eine zweite Erhebung vorgesehen werden, die dann - in analoger Weise zur ersten Erhebung - beim Anordnen der Leiterbahnen gemäß Schritt b) zur Ausbildung der gemeinsamen Kontaktzone an der dem zweiten Fügeabschnitt der zweiten Leiterbahn zugewandten Oberfläche des ersten Fügeabschnitts zur Anlage gebracht werden kann. Auf diese Weise kann die effektive Kontaktfläche zwischen den beiden Fügeabschnitten klein gehalten werden, so dass der im Zuge eines Schweißvorgangs zum Herstellen einer stoffschlüssigen Verbindung zwischen beiden Fügeabschnitten fließende elektrische Strom nur durch eine kleine Kontaktzone strömt. Somit erfolgt die Materialaufschmelzung für den Stoffschluss zunächst in der sehr kleinen Kontaktzone und erst anschließend in dem die Kontaktzone umgebenden Fügebereich der Fügezone. Auf diese Weise wird eine verbesserte Schweißnaht gebildet.

Eine besonders gute stoffschlüssige Verbindung kann in einer vorteilhaften Weiterbildung der vorangehend erläuterten Ausführungsform erzeugt werden, wenn eine Mehrzahl von ersten und/oder zweiten Erhebungen vorgesehen werden, wobei die Erhebungen bezüglich einer Draufsicht rasterartig oder gitterartig auf einer dem zweiten Fügeabschnitt zugewandten ersten Oberfläche des ersten Fügeabschnitts oder auf einer dem ersten Fügeabschnitt zugewandten zweiten Oberfläche des zweiten Fügeabschnitts angeordnet werden.

In einer vorteilhaften Weiterbildung der Erfindung können die ersten und/oder zweiten Erhebungen derart ausgebildet werden, dass sie wenigstens einen Fügebereich vollständig einfassen. Auf diese Weise kann verhindert werden, dass im Zuge von Schritt c) beim Einspritzen von Kunststoff in die Spritzgießform dieser in die Fügebereich eindringen und unter Umständen den elektrischen Kontakt zwischen den elektrisch zu verbindenden Leiterbahnen mindern kann.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch
- Fig. 1: ein Beispiel einer Mehrzahl von ersten und zweiten Leiterbahnen vor dem Umspritzen mit Kunststoff,
- Fig. 2: eine grobschematische Darstellung einer ersten und einer zweiten Leiterbahn nach dem Anordnen in einem Formwerkzeug,
- Fig. 3: die erste und zweite Leiterbahn der Figur 1 nach dem Umspritzen mit Kunststoff,
- Fig.4: eine Detaildarstellung der Leiterbahnen der Figur 1 im Bereich einer gemeinsamen Kontaktzone,
- Fig. 5: eine Draufsicht auf eine die Kontaktzone ausbildende Oberfläche der ersten Leiterbahn.

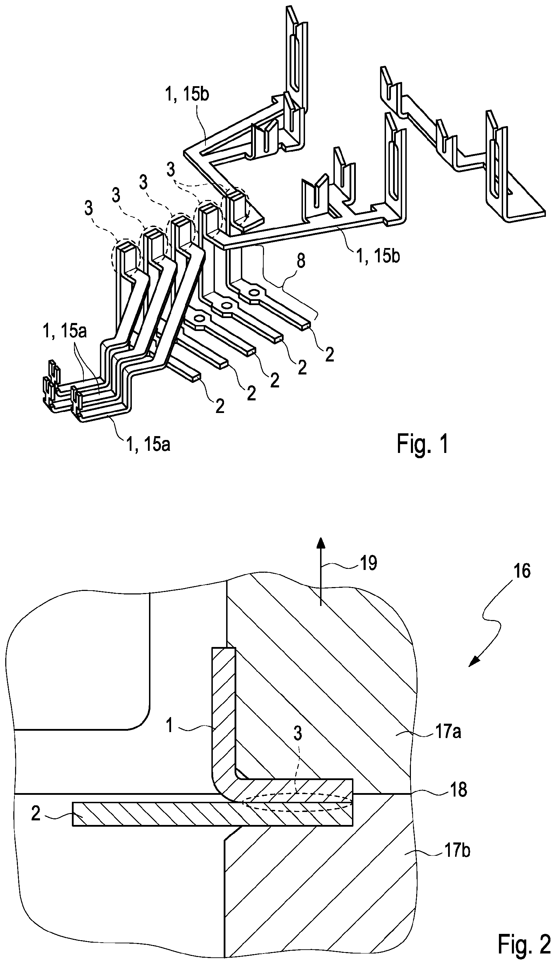

Figur 1 zeigt eine Mehrzahl von ersten Leiterbahnen 1 und eine Mehrzahl von zweiten Leiterbahnen 2, die in einem ersten Verfahrensschritt a) in Form von Blechformteilen bereitgestellt werden. Hierzu können die Blechformteile aus einer oder mehreren Blechbahnen ausgestanzt werden. Mittels eines auf das Ausstanzen folgenden mittels Umformvorgangs, typischerweise mittels Biegen und/oder Abkanten, können die Blechformteile derart umgeformt werden, dass sie sich wie in Figur 1 gezeigt in alle drei Raumrichtungen des dreidimensionalen Raums erstrecken.

Im Beispiel der Figur 1 weisen die zusätzlich mit dem Bezugszeichen 15a bezeichneten ersten Leiterbahnen 1 eine andere Geometrie auf als die zusätzlich mit dem Bezugszeichen 15b bezeichneten ersten Leiterbahnen 1. Das hier vorgestellte, erfindungsgemäße Verfahren gestattet also die Herstellung einer Anordnung mit unterschiedlichen Leiterbahn-Geometrien. Es versteht sich, dass auch zweite Leiterbahnen 2 mit unterschiedlichen Geometrien (in Figur 1 nicht gezeigt) gewählt werden können. Für den Fachmann eröffnen sich somit vielfältige Variationsmöglichkeiten.

Der Darstellung der Figur 2 entnimmt man, dass die ersten Leiterbahnen 1 und die zweiten Leiterbahnen 2 im Zuge des Verfahrensschritts b) derart in einer Spritzgießform eines Spritzwerkzeugs 16 angeordnet werden, dass jede erste Leiterbahn 1 in einer gemeinsamen Kontaktzone 3 eine ihr zugeordnete zweite Leiterbahn 2 zum Herstellen einer elektrischen Verbindung zwischen den Leiterbahnen 1, 2 mechanisch kontaktiert (in Figur 2 ist der Übersichtlichkeit halber nur eine erste Leiterbahn 1 und eine zweite Leiterbahn 2 dargestellt). Wie Figur 2 erkennen lässt, kann das Spritzgieß- bzw. Formwerkzeug 16 ein erstes und ein zweites Formteil 17a, 17b aufweisen. Der mit 19 bezeichnete Pfeil zeigt die Öffnungsrichtung des Spritzwerkzeugs 16. Die Kontaktzone 3 befindet sich vorzugsweise im Bereich der Formtrennung 18 zwischen den beiden Formteilen 17a, 17b.

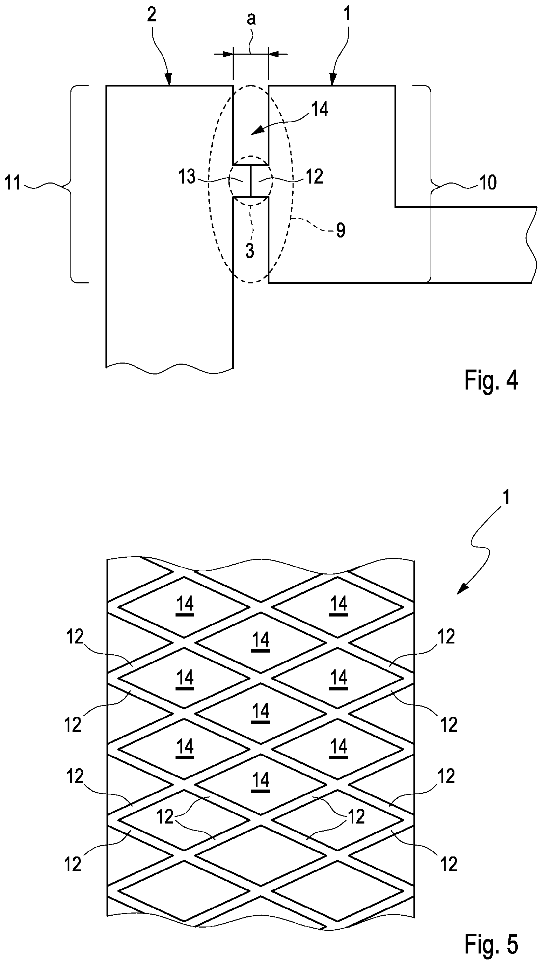

In Figur 4 ist die gemeinsame Kontaktzone 3 zwischen der ersten Leiterbahn 1 und der zweiten Leiterbahn 2 vergrößert und in einer Seitenansicht dargestellt. Wie Figur 4 erkennen lässt, sind die erste Leiterbahn 1 und die zweite Leiterbahn 2 derart zueinander angeordnet, dass die gemeinsame Kontaktzone 3 Teil einer gemeinsamen Fügezone 9 ist, die durch einen ersten Fügeabschnitt 10 der ersten Leiterbahn 1 und durch einen zweiten Fügeabschnitt 11 der zweiten Leiterbahn 2 gebildet wird. Im Bereich der Fügezone 9 sind die beiden Fügeabschnitte 10, 11 im Abstand zueinander angeordnet, wobei dieser Abstand höchstens einen vorbestimmten Maximalwert a aufweist. In der Kontaktzone 3, die Teil der Fügezone 9 ist, nimmt dieser Abstand einen Nullwert an, d.h. die beiden Fügeabschnitte 10, 11 liegen in der Kontaktzone flächig aneinander an. In dem zur Kontaktzone 3 komplementären Fügebereich 14 der Fügezone 9 sind die beiden Fügeabschnitte 10, 11 im Abstand zueinander angeordnet, wobei dieser Abstand höchstens einen vorbestimmten Maximalwert a aufweist. Beispielsweise kann der den Bereich der Fügezone 9 definierende vorbestimmte Maximalwert a für den Abstand der Fügeabschnitte 10, 11 1mm betragen. Bevorzugt beträgt der Maximalwert 0,5mm, besonders bevorzugt 0,1mm.

Zur Ausbildung der gemeinsamen Kontaktzone 3, in welcher die beiden Fügeabschnitte 10, 11 aneinander anliegen, also vor dem stoffschlüssigen Verbinden gemäß Schritt d) mechanisch miteinander in Kontakt stehen, kann wie in Figur 4 gezeigt auf der dem zweiten Fügeabschnitt 11 der zweiten Leiterbahn 2 zugewandten Oberfläche des ersten Fügeabschnitts 10 eine erste Erhebung 12 vorgesehen werden. Dies kann insbesondere im Zuge des Umformens der Blechformteile geschehen. Alternativ oder zusätzlich kann auf der dem ersten Fügeabschnitt 10 der ersten Leiterbahn 1 zugewandten Oberfläche des zweiten Fügeabschnitts 11 eine zweite Erhebung 13 vorgesehen werden. Die Figur 4 zeigt den Spezialfall, dass die beiden Erhebungen 12, 13 der ersten bzw. zweiten Leiterbahn 1, 2 zur Ausbildung der Kontaktzone 3 aneinander anliegen.

Besonders bevorzugt kann eine Mehrzahl von ersten und/oder zweiten Erhebungen 12, 13 vorgesehen werden, wobei die Erhebungen 12, 13 bezüglich einer Draufsicht rasterartig oder gitterartig auf der ersten Oberfläche des ersten Fügeabschnitts 10 oder auf der zweiten Oberfläche des zweiten Fügeabschnitts 11 angeordnet sind. Dies ist exemplarisch in der Darstellung der Figur 5 gezeigt, welche eine Draufsicht auf die der zweiten Leiterbahn 2 zugewandten Oberfläche der ersten Leiterbahn wiedergibt. Man erkennt, dass eine Mehrzahl von ersten Erhebungen 12 vorgesehen ist, die eine gitterartige Struktur ausbilden. Die Struktur des Gitters kann wie in Figur 5 gezeigt eine rautenartige Geometrie aufweisen. Durch die Erhebungen 12 werden mehrere Fügebereiche 14 vollständig eingefasst. Auf diese Weise kann verhindert werden, dass Kunststoff beim Einspritzen in die vollständig eingefassten Fügebereiche 14 gelangen kann und den elektrischen Kontakt zwischen den beiden Leiterbahnen 1, 2 mindert. In Varianten des Beispiels ist auch eine rasterartige Anordnung der Erhebungen 12 denkbar (nicht gezeigt). Gegenüber einer gitterartigen Struktur kann auf diese Weise die Kontaktfläche zwischen beiden Leiterbahnen 1, 2 nochmals reduziert werden. Auch auf der der ersten Leiterbahn 1 zugewandten Oberfläche der zweiten Leiterbahn 2 können die Erhebungen 13 eine gitterartige Struktur wie in Figur 5 anhand der ersten Leiterbahn erläutert - ausbilden. Daher sind obige Erläuterungen zur ersten Leiterbahn 1 mutatis mutandis anwendbar.

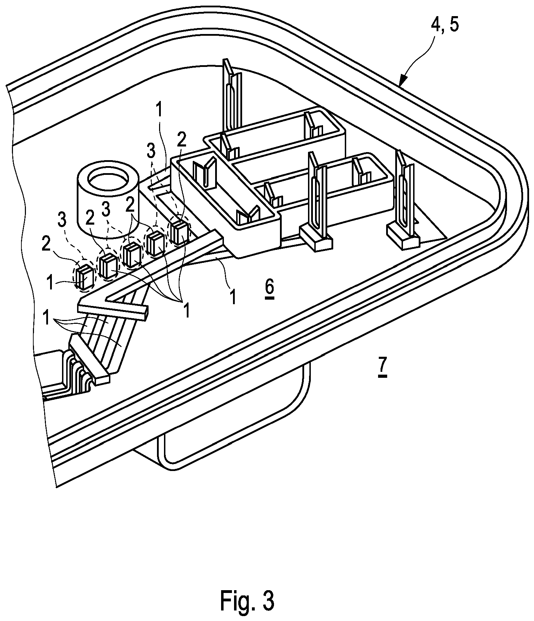

In einem dritten Verfahrensschritt c) werden die ersten Leiterbahnen 1 und die zweiten Leiterbahnen 2 zur Ausbildung eines Gehäuseteils 4 wenigstens teilweise mit einem Kunststoff umspritzt. Auf diese Weise werden die Leiterbahnen 1, 2 am Gehäuseteil 4 fixiert, so dass dieses für die Leiterbahnen 1,2 als Trägerteil fungieren kann. Ein solches Gehäuseteil 4 zeigt die Figur 3. Das Gehäuseteil 4 kann Teil eines mehrteiligen Gehäuses sein (nicht gezeigt), in welchem die Leiterbahnen 1, 2 verbaut werden sollen.

Im Beispiel der Figur 3 handelt es sich bei dem Gehäuseteil 4 um einen Gehäusedeckel 5, der zusammen mit einem Gehäuseboden (nicht gezeigt) einen Gehäuseinnenraum 6 begrenzt. Der Figur 3 entnimmt man, dass das Umspritzen derart erfolgen kann, dass die zweiten Leiterbahnen 2 durch das Gehäuseteil 4 durchgeführt sind. Im Beispiel der Figur 3 bilden die vom Gehäuseinnenraum 6 durch das Gehäuseteil 4 nach außen in die Umgebung 7 durchgeführten Endabschnitte (in Figur 3 durch das Gehäuseteil 4 verdeckt, in Figur 1 mit 8 bezeichnet) elektrische Anschlüsse aus, die außen, also auf der der Umgebung 7 zugewandten Seite des Gehäuseteils 4 angeordnet sind.

In einem vierten Verfahrensschritt d) wird jede der ersten Leiterbahnen 1 mit der ihr zugeordneten zweiten Leiterbahn 2 im Bereich der Kontaktzone 3 stoffschlüssig, bevorzugt mittels einer Schweißverbindung, verbunden. Auf diese Weise wird eine dauerhafte elektrische Verbindung zwischen der ersten Leiterbahnen 1 und der jeweiligen zweiten Leiterbahn 2 hergestellt. Vorzugsweise erfolgt das stoffschlüssige Verbinden gemäß Schritt d) erst nach Abkühlen des Gehäuseteils 4 unter einen vorbestimmten Temperatur-Schwellwert.

Im Beispiel der Figur 4 beschränkt sich die effektive Kontaktfläche, durch welche beim Schweißvorgang elektrischer Strom fließt, auf die Erhebungen 12, 13. Somit erfolgt die Materialaufschmelzung für den Stoffschluss zwischen den Leiterbahnen 1, 2 zunächst in der sehr kleinen Kontaktzone und erst anschließend in dem die Kontaktzone umgebenden Fügebereich der Fügezone. Auf diese Weise wird eine verbesserte Schweißnaht gebildet.

## Patentansprüche

1. Verfahren zur Herstellung einer Anordnung mit einem Gehäuseteil (4) und wenigstens zwei Leiterbahnen (1, 2) aus Blechformteilen, umfassend die folgenden Schritte:
a) Bereitstellen wenigstens eines eine erste Leiterbahn (1) ausbildenden Blechformteils und wenigstens eines eine zweite Leiterbahn (2) ausbildenden Blechformteils,
b) Anordnen der wenigstens einen ersten Leiterbahn (1) und der wenigstens einen zweiten Leiterbahn (2) in einer Spritzgussform derart, dass die wenigstens eine erste Leiterbahn (1) zum Herstellen einer elektrischen Verbindung die wenigstens eine zweite Leiterbahn (2) in einer gemeinsamen Kontaktzone (3) mechanisch kontaktiert,
c) Zumindest teilweises Umspritzen der wenigstens eine ersten Leiterbahn (1) und der wenigstens einen zweiten Leiterbahn (2) mit einem Kunststoff zur Ausbildung eines gemeinsamen Gehäuseteils (4) für die beiden Leiterbahnen (1, 2)
d) Stoffschlüssiges Verbinden der wenigstens einen ersten Leiterbahn (1) und der wenigstens einen zweiten Leiterbahn (2) im Bereich der gemeinsamen Kontaktzone (3),
**dadurch gekennzeichnet, dass**
die Durchführung von Schritt d) zeitlich nach der Durchführung von Schritt c) erfolgt.

2. Verfahren nach Anspruch 1,
**dadurch gekennzeichnet, dass**
das stoffschlüssige Verbinden gemäß Schritt d) erst nach Abkühlen des Gehäuseteils (4) unter einen vorbestimmten Temperatur-Schwellwert durchgeführt wird.

3. Verfahren nach einem der vorhergehenden Ansprüche,
**dadurch gekennzeichnet, dass**
in Schritt a) wenigstens zwei erste Leiterbahnen (1) und wenigstens zwei zweite Leiterbahnen (2) in Form von jeweiligen Blechformteilen bereitgestellt werden, so dass in Schritt b) für jede erste Leiterbahn (1) und jede zweite Leiterbahn (2) jeweils eine gemeinsame Kontaktzone (3) ausgebildet wird, wobei wenigstens zwei erste Leiterbahnen (1) eine zueinander verschiedene Geometrie aufweisen und/oder wenigstens zwei zweite Leiterbahnen (2) eine zueinander verschiedene Geometrie aufweisen.

4. Verfahren nach einem der vorhergehenden Ansprüche,
**dadurch gekennzeichnet, dass**
das stoffschlüssige Verbinden durch Verschweißen oder Verlöten der wenigstens einen ersten Leiterbahn (1) mit der wenigstens einen zweiten Leiterbahn (2) im Bereich der gemeinsamen Kontaktzone (3) erfolgt.

5. Verfahren nach Anspruch 3 oder 4,
**dadurch gekennzeichnet, dass**
- bei der Ausbildung der Leiterbahnen (1, 2) gemäß Schritt a) auf der Oberfläche des ersten Fügeabschnitts (10) wenigstens eine erste Erhebung (12) vorgesehen wird, die beim Anordnen der Leiterbahnen (1, 2) in der Spritzgießform gemäß Schritt b) zur Ausbildung der gemeinsamen Kontaktzone (3) an der dem ersten Fügeabschnitt (10) der ersten Leiterbahn (1) zugewandten Oberfläche des zweiten Fügeabschnitts (11) anliegt, und/oder dass
- bei der Ausbildung der Leiterbahnen (1, 2) gemäß Schritt a) auf der Oberfläche des zweiten Fügeabschnitts (11) wenigstens eine zweite Erhebung (13) vorgesehen wird, die beim Anordnen der Leiterbahnen (1, 2) in der Spritzgießform gemäß Schritt b) zur Ausbildung der gemeinsamen Kontaktzone (3) an der dem zweiten Fügeabschnitt (11) der zweiten Leiterbahn (2) zugewandten Oberfläche des ersten Fügeabschnitts (10) anliegt.

6. Verfahren nach Anspruch 5,
**dadurch gekennzeichnet, dass**
die wenigstens erste und/ oder zweite Erhebung (12, 13) in einer Draufsicht auf die Oberfläche des ersten oder zweien Fügeabschnitts (10, 11) eine gitterartige Struktur besitzt.

7. Verfahren nach Anspruch 5 oder 6,
**dadurch gekennzeichnet, dass**
die ersten und/oder zweiten Erhebungen (12, 13) derart ausgebildet werden, dass sie wenigstens einen Fügebereich (14) vollständig einfassen.

## Claims

1. Method for producing an arrangement with a housing part (4) and at least two conductor tracks (1, 2) made of sheet-metal form parts, comprising the following steps:
a) providing at least one sheet metal form part forming a first conductor track (1) and at least one sheet metal form part forming a second conductor track (2)
b) arranging at least one first conductor track (1) and at least one second conductor track (2) in an injection mould such that at least one first conductor track (1), mechanically contacts at least one second conductor track (2) in a common contact zone (3), to establish an electrical connection
c) at least partially encapsulating at least one first conductor track (1) and at least one second conductor track (2) with a plastic to form a common housing part (4) for the two conductor tracks (1, 2)
d) material-closure connecting at least one first conductor track (1) and at least one second conductor track (2) in the region of said common contact zone (3),
**characterised in that**
the execution of step d) takes place after execution of step c)

2. Method according to claim 1,
**characterised in that**
the material-closure connecting according to step d) is carried out only after cooling the housing part (4) below a predetermined temperature threshold.

3. Method according to one of the preceding claims,
**characterised in that**
in step a) at least two first conductor tracks (1) and at least two second conductor tracks (2) are provided in the form of respective sheet metal form parts, so that in step b) for each first conductor track (1) and each second conductor track (2) in each case a common contact zone (3) is formed, wherein at least two first conductor tracks (1) have a mutually different geometry and / or at least two second conductor tracks (2) have a mutually different geometry.

4. Method according to one of the preceding claims
**characterised in that**
the material-closure connecting takes place by welding or soldering at least one first conductor track (1) with at least a second conductor track (2) in the region of the common contact zone (3).

5. Method according to claim 3 or 4,
**characterised in that**
- for the formation of the conductor tracks (1, 2) according to step a) on the surface of the first joining portion (10) at least a first elevation (12) is provided, which when arranging the conductor tracks (1, 2) in the injection mould according to step b) to form the common contact zone (3) on which the surface of the second joining portion (11) facing the first joining portion (10) of the first conductor track (1) lies and / or that
- when forming the conductor tracks (1, 2) according to step a) on the surface of the second joining portion (11) at least a second elevation (13) is provided which when arranging the conductor tracks (1, 2) in the injection mould according to step b) for forming the common contact zone (3) on the second joining portion (11) the surface of the first joining portion (10) facing the second conductor track (2) lies.

6. Method according to claim 5,
**characterised in that**
at least first and / or second elevation (12, 13) in a plan view of the surface of the first or second joining portion (10, 11) has a grid-like structure.

7. Method according to claim 5 or 6,
**characterised in that**
the first and / or second elevations (12, 13) are formed such that they surround at least one joining region (14).

## Revendications

1. Procédé de fabrication d'un ensemble avec une pièce de boîtier (4) et au moins deux pistes conductrices (1, 2) à partir de pièces moulées en tôle, comprenant les étapes suivantes :
a) fourniture d'au moins une pièce moulée en tôle formant une première piste conductrice (1) et d'au moins une pièce moulée en tôle formant une deuxième piste conductrice (2),
b) agencement de l'au moins une première piste conductrice (1) et de l'au moins une deuxième piste conductrice (2) dans un moule pour coulage par injection de telle sorte que, pour établir une liaison électrique, l'au moins une première piste conductrice (1) est en contact mécanique avec l'au moins une deuxième piste conductrice (2) dans une zone de contact commune (3),
c) injection au moins partielle d'un plastique autour de l'au moins une première piste conductrice (1) et de l'au moins une deuxième piste conductrice (2) afin de former une pièce de boîtier (4) commune pour les deux pistes conductrices (1, 2),
d) liaison par matière de l'au moins une première piste conductrice (1) et de l'au moins une deuxième piste conductrice (2) dans la région de la zone de contact commune (3),
**caractérisé en ce que** l'exécution de l'étape d) s'effectue chronologiquement après l'exécution de l'étape c).

2. Procédé selon la revendication 1, **caractérisé en ce que** la liaison par matière selon l'étape d) n'est effectuée qu'après le refroidissement de la pièce de boîtier (4) au-dessous d'une valeur de seuil de température prédéterminée.

3. Procédé selon l'une quelconque des revendications précédentes, **caractérisé en ce que**, à l'étape a), au moins deux premières pistes conductrices (1) et au moins deux deuxièmes pistes conductrices (2) sont fournies sous la forme de pièces moulées en tôle respectives de telle sorte que, à l'étape b), une zone de contact commune (3) est formée pour chaque première piste conductrice (1) et pour chaque deuxième piste conductrice (2), au moins deux premières pistes conductrices (1) présentant une géométrie différente l'une de l'autre et au moins deux deuxièmes pistes conductrices (2) présentant une géométrie différente l'une de l'autre.

4. Procédé selon l'une quelconque des revendications précédentes, **caractérisé en ce que** la liaison par matière s'effectue par soudage ou brasage de l'au moins une première piste conductrice (1) avec l'au moins une deuxième piste conductrice (2) dans la région de la zone de contact commune (3).

5. Procédé selon la revendication 3 ou 4, **caractérisé en ce que**
- lors de la formation des pistes conductrices (1, 2) selon l'étape a), au moins une première bosse (12) est prévue sur la surface du premier tronçon de joint (10), laquelle bosse est adjacente, lors de l'agencement des pistes conductrices (1, 2) dans le moule pour coulage par injection selon l'étape b), à la surface, proche du premier tronçon de joint (10) de la première piste conductrice (1), du deuxième tronçon de joint (11) dans le but de former la zone de contact commune (3), et/ou
- lors de la formation des pistes conductrices (1, 2) selon l'étape a), au moins une deuxième bosse (13) est prévue sur la surface du deuxième tronçon de joint (11), laquelle bosse est adjacente, lors de l'agencement des pistes conductrices (1, 2) dans le moule pour coulage par injection selon l'étape b), à la surface, proche du deuxième tronçon de joint (11) de la deuxième piste conductrice (2), du premier tronçon de joint (10) dans le but de former la zone de contact commune (3).

6. Procédé selon la revendication 5, **caractérisé en ce que** l'au moins une première et/ou deuxième bosse (12, 13) présente, en vue de dessus sur la surface du premier ou deuxième tronçon de joint (10, 11), une structure en grille.

7. Procédé selon la revendication 5 ou 6, **caractérisé en ce que** les premières et/ou deuxièmes bosses (12, 13) sont réalisées de telle sorte qu'elles englobent complètement au moins une région de joint (14).
